Europäisches Patentamt

European Patent Office

Office européen des brevets

(19)

(11) Veröffentlichungsnummer: **0 204 901**

**A2**

(12) **EUROPÄISCHE PATENTANMELDUNG**

(21) Anmeldenummer: **86103559.0**

(22) Anmeldetag: **17.03.86**

(51) Int. Cl.⁴: **H05K 3/00**

(30) Priorität: **10.06.85 IT 2108985**

(43) Veröffentlichungstag der Anmeldung:
**17.12.86 Patentblatt 86/51**

(84) Benannte Vertragsstaaten:
**AT BE CH DE FR GB LI LU NL SE**

(71) Anmelder: **Curti, Ezio**
**Strada Padana Superiore 57/59**
**I-20063 Cernusco sul Naviglio(IT)**

(72) Erfinder: **Curti, Ezio**
**Strada Padana Superiore 57/59**
**I-20063 Cernusco sul Naviglio(IT)**

(74) Vertreter: **Mayer, Hans Benno**
**Via dell'Orso 7/A**
**I-20121 Milano(IT)**

(54) **Verfahren und Vorrichtung zum registergenauen Aufdruck eines elektronischen Schaltkreises gegenueber den Bezugsbohrungen einer Traegerplatte.**

(57) Die Erfindung betrifft ein Verfahren, sowie eine Vorrichtung zum registergenauen Aufdrucken eines elektronischen Schaltkreises gegenueber den Bezugsbohrungen einer Traegerplatte. Durch Erkennungsmittel wird die Lage von mindestens zwei in die Traegerplatte eingebrachte Bezugsbohrungen gelesen und abgespeichert und bildlich sichtbar gemacht. In einem anschliessenden Vorgang wird die genaue Lage jenes Teiles des Schaltkreises gespeichert, der die genannten Bezugsbohrungen umgibt. Im Anschluss daran erfolgt ein Vergleich zwischen der Lage der Bezugsbohrung, sowie der Lage der gedruckten Teile des Schaltkreises und, unter Zuhilfenahme von steuerbaren Motoren, die mit Transduktoren, Encodern oder aehnlichen Lageerfassungsmitteln zusammenarbeiten, wird der Druckrahmen zu einer eventuellen Korrekturbewegung entlang der Achsen (X, Y) verschoben, bzw. um eine Achse Z verschwenkt.

FIG 3

Xerox Copy Centre

EP 0 204 901 A2

## Verfahren und Vorrichtung zum registergenauen Aufdruck eines elektronischen Schaltkreises gegenueber den Bezugsbohrungen einer Traegerplatte"

Die vorstehende Erfindung betrifft ein Verfahren, sowie eine Vorrichtung, die es erlauben, das Bild eines elektronischen Schaltkreises registergenau gegenueber den Bezugsbohrungen, die in einem vorangegangenen Stanz-oder Bohrvorgang in die Traegerplatte eingebracht wurden, aufzudrucken.

Es ist bekannt, dass in Traegerplatten fuer gedruckte Schaltungen, ueblicherweise eine groessere Anzahl von Bohrungen eingestanzt oder eingebohrt wird. Diese Bohrungen sind vorgesehen, um in einem folgenden Arbeitsgang elektrische Bauteile aufzunehmen. Desweiteren sind diese Bohrungen von aufgedruckten Ringen umgeben, die elektrisch leitend sind und leitend mit dem restlichen Verlauf des elektronischen Schaltkreises in Verbindung stehen. Es ist auch bekannt, dass auf die mit Bohrungen versehenen Traegerplatte der elektronische Schaltkreis unter Zuhilfenahme von Siebdruckverfahren aufgebracht wird. Zu diesem Zwecke befindet sich ueblicherweise ueber der Traegerplatte, die in Druckposition gebracht ist, ein Druckrahmen, der die Siebdruckmatrize aufnimmt, die den elektronischen Schaltkreis wiedergibt, der auf die darunterliegende Traegerplatte zu uebertragen ist.

Es ist ferner bekannt, dass die genannten Kreise des Stromlaufplanes des elektronischen Schaltkreises, Kreise die die Bohrungen der Traegerplatte umgeben, genau koaxial gegenueber den Bohrungen angebracht werden muessen, um somit die Herstellung eines qualitativ hochwertigen Schaltkreises zu ermoeglichen.

Es genuegt, dass einige Leiterkreise des elektrisch leitenden Schaltkreises zu stark gegenueber den in die Leiterplatte eingestanzten Bohrungen versetzt sind, um wesentlich die Zuverlaessigkeit des fertigen Schaltkreises zu vermindern, oder sogar zu Ausschuss des fertigen Schaltkreises zu fuehren.

Mit dem Versuch, diese Nacheile zu vermeiden, wurden bereits Siebdruckrahmen vorgeschlagen, die ueber Handraeder in Richtung der Achsen X und Y eines Koordinatensystemes verfahrbar angeordnet sind. Ferner ist es bekannt, ein weiteres Handrad vorzusehen, mit dem es moeglich ist, den Siebdruckrahmen um eine Achse Z zu verschwenken. Diese bekannte Vorrichtung hat sich jedoch als nicht bauchbar erwiesen, da einmal die Einstellarbeiten erhebliche Zeit fuer das Justieren des Siebdruckrahmens in Bezug auf die Traegerplatte in Anspruch nehmen. Ferner, um den Siebdruckrahmen gegenueber der Traegerplatte ausrichten zu koennen, ist es erforderlich, in Probelaeufen eine erhebliche Anzahl bereits mit Bohrungen versehener, teuerer Traegerplatten zu bedrucken. Dies macht sich besonders unangenehm beim Bedrucken von mehrschichtig aufgebauten Traegerplatten bemerkbar, denn es sind mehrere Platten zu bedrucken, bevor Registergenauigkeit zwischen den Kreisen des Stormlaufplanes und den in die Traegerplatte eingebrachten Bohrungen erreicht wird.

Aufgabe der vorstehenden Erfindung ist es, ein neues Verfahren und eine entsprechende Vorrichtung vorzuschlagen, die er ermoeglicht, die vorgenannte Lageeinstellung automatisch und vor allem rasch durchzufuehren, wobei es nicht erforderlich ist, fuer den Einstellvorgang in Proebelaeufen Traegerplatten zu bedrucken.

Erfindungsgemaess wird diese Aufgabe durch ein Verfahren geloest, das folgende Bearbeitungsvorgaenge vorsieht:

a) ungefaehrens Ausrichten des Siebdruckrahmens gegenueber der zu bedruckenden Traegerplatte des elektronischen Schaltkreises;

b) bildliche Darstellung von wenigstens zwei in die Traegerplatte eingebrachten Bohrungen, sowie Abspeichern der Lagekoordinaten fuer diese Bohrungen;

c) Aufdrucken des Bildes des elektronischen Schaltkreises auf eine mit einer Schutzschicht, z.B. einem Papierblatt abgedeckten Traegerplatte;

d) bildliche Darstellung der Ringe des elektronischen Schaltkreises, die den Bohrungen zugeordnet sind, sowie Abspeichern der Lagekoordinaten dieser Ringe des elektronischen Schaltkreises.

e) Vergleich der Lagekoordinaten der Bohrungen der Traegerplatte mit den Lagekoordinaten, der auf die Schutzschicht der Traegerplatte aufgedruckten Ringe des Schaltkreises;

f) Lagekorrektur durch Verschieben des Druckrahmens in Richtung der Achsen X, Y und Verschwenken um die Achse Z.

Die Vorrichtung zur Durchfuehrung des erfindungsgemaessen Verfahrens besteht aus zwei in ihrer Lage einstellbaren Fernsehkameras, die mindestens zwei Bohrungen der Traegerplatte zugeordnet sind, wobei die Fersehkameras mit einem Mikroprozessor wirkverbunden sind, dessen Ausgaenge mit entsprechenden Videoterminals in Verbindung stehen und, dass ferner der Siebdruckrahmen mit steuerbaren Stellmotoren wirkverbunden ist, wobei diese Motoren Steuer-und Kontrolleinrichtungen aufweisen, um eine gesteuerte Verschiebung in Richtung der Achsen (X, Y) zu ermoeglichen und, dass der Siebdruckrahmen mit einem weiteren steuerbaren Stellmotor mit Steuer-und Kontrolleinrichtungen wirkverbunden ist, um ein Verschwenken des Siebdruckrahmens um eine Achse (Z) zu ermoeglichen und, dass ferner die Steuer-und Kontrolleinrichtungen mit dem Mikroprozessor wirkverbunden sind. Mit dem erfindungsgemaessen Verfahren, sowie der dazugehoerigen Vorrichtung wird es ermoeglicht, eine registergenaue Einstellung des Siebdruckrahmens gegenueber der Traegerplatte des elektronischen Schaltkreises vorzunehmen, in der Art, dass die in die Traegerplatte eingebrachten Bohrungen nach dem Aufdrucken des Schaltkreises koaxial, d.h. registergenau von den entsprechenden Ringen des elektronischen Schaltkreises umgeben werden. Die registergenaue Ausrichtung erfolgt vollkommen automatisch. Es ist nicht erforderlich, teure Traegerplatten fuer Probedrucke zu verbrauchen. Der aufgedruckte Schaltkreis wird staendig hinsichtlich seiner Lage gegenueber den Bohrungen kontrolliert und eventuelle Verschiebungen von den eingespeicherten Nominalwerten werden sofort durch die Vorrichtung ausgeglichen.

Der Erfindungsgegenstand wird nun genauer anhand eines Ausfuehrungsbeispieles beschrieben und in in den beigefuegten Zeichnungen schematisch dargestellt.

Es zeigen:

Fig. 1 schematisch den Vorgang, bei dem die genaue Lage von zwei in die Traegerplatte eingebrachten Bohrungen erfasst und abgespeichert wird;

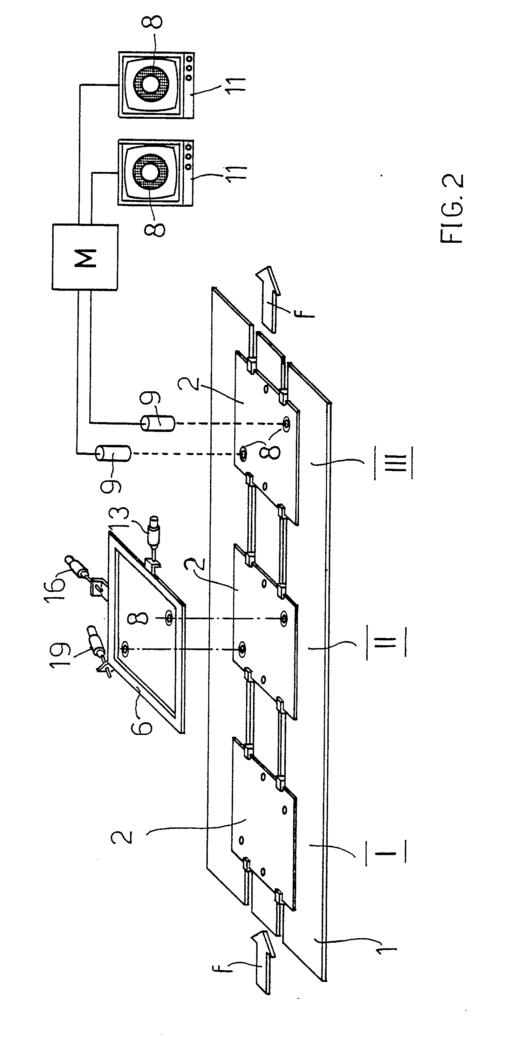

Fig. 2 zeigt schematisch den Vorgang, mit dem die Lage von zwei die Bohrungen umgebenden Schaltkreisringen erfasst und abgespeichert wird;

Fig. 3 zeigt schematisch den Vergleichsvorgang zwischen der Lage der in die Traegerplatte eingebrachten Bohrungen und der die Bohrungen nach dem Siebdruckvorgang umgebenden Ringe des Schaltkreises.

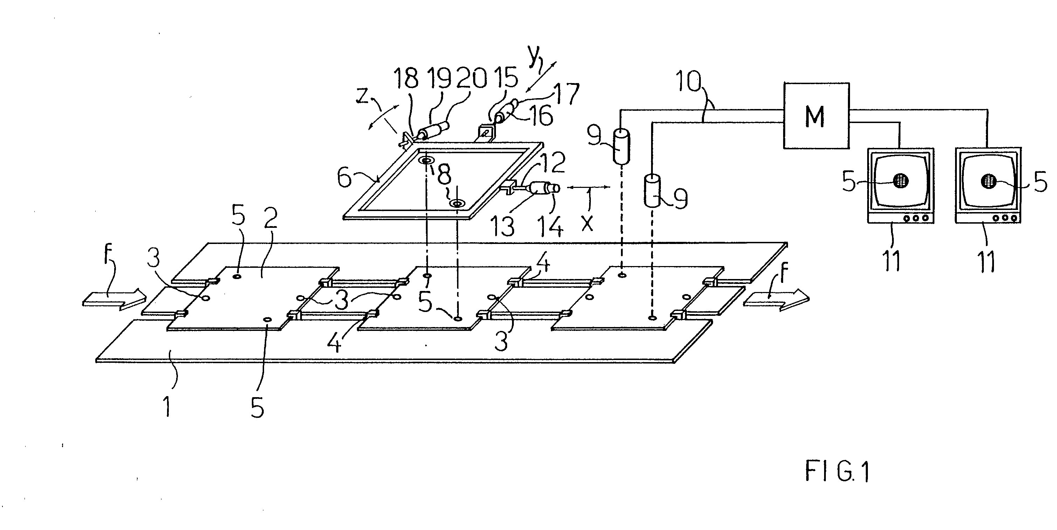

Wie der Fig. 1 zu entnehmen ist, werden auf einem Drucktisch 1 Traegerplatten 2 zugefuehrt, die Bezugsbohrungen 3 aufweisen. Mit diesen Bezugsbohrungen 3 treten bekannte Bezugsstifte in Wirkverbindung, die in einstellbarer, fester Lage am Drucktisch 1 der Maschine angeordnet sind. Ferner, unter Zuhilfenahme bekannter Greifervorrichtungen 4 werden die Platten in Richtung der Pfeile f aus einer Beschickungszone (I) in eine Druckzone (II) und von hier in eine Pruef-und Kontrollzone (III) befoerdert. Die Zone III ist auch gleichzeitig zum Entladen der gerückten Platten vorgesehen.

Die Traegerplatten 2 weisen ferner Bohrungen 5 auf, die in einem vorangegangenen Arbeitsgang in die Traegerplatte eingebohrt oder eingestanzt wurden. Aus Gruenden der Einfachheit sind lediglich zwei Bohrungen dargestellt, die in vorteilhafter Weise in diagonal gegenueberliegender Lage angeordnet sind, Die Bohrungen, die in dieser Lage angeordnet sind, eignen sich am besten fuer Kontrollzwecke und registergenaues Ausrichten. Es ist einleuchtend, dass eine Traegerplatte zur Aufnahme eines gedruckten elektronischen Schaltkreises eine Vielzahl dieser Bohrungen 5 aufweist, die ueber die gesamte Plattenflaeche verteilt sind.

In der Druckzone II ist ein Siebdruckrahmen 6 vorgesehen, der mit einem bekannten, elastischen Drucktuch 7 ausgeruestet ist, das das Bild 8 aufnimmt, das mittels Siebdruckverfahren registergenau auf die darunter liegende Platte aufzudrucken ist. In Fig. 1 ist aus Gruenden der Uebersichtlichkeit der Rahmen 6 wesentlich ueber den Platte 2 dargestellt, doch in Wirklichkeit befindet sich der Rahmen 6 in geringem Abstand ueber der Traegerplatte 2. Wegen der bereits aufgefuehrten Gruende ist es wichtig, dass die ringfoermigen Abbildungen 8 genau koaxial, d.h. registergenau zu den in die Traegerplatte 2 eingestanzten Bohrungen 2 aufgedruckt werden. Daher ist es unumgeanglich, dass der Druckrahmen 6 gesteuert bezueglich der Achsen X und Y eines Koordinatensystemes verfahrbar angeorndet ist. Ferner ist es erwuenscht, den Druckrahmen 6 um eine Achse Z verschwenkbar anzuordnen, wie dies durch den entsprechenden Pfeil angedeutet ist.

Aus diesem Grunde ist der Druckrahmen 6 verschiebbar, sowie verschenkbar gelagert; desweiteren ist der Rahmen mit einer Antriebsspindel 12 wirkverbunden, die von einem steuerbaren Motor 13 angetrieben wird, dem ein verdrehbarer Encoder 14 oder ein aehnliches Lageerfassungsmittel zugeordnet ist. Der Rahmen 6 ist mit einer Antriebsspindel 5 wirkverbunden, die durch einen steuerbaren Motor 16 antreibbar ist, dem ein verdrehbarer Encoder 17 oder ein gleichartiges Lageerfassungsmittel zugeordnet ist. Zur Durchfuehrung der Schwenkbewegung (Pfeil Z) ist der Rahmen 6 an einer Ecke mit einer weiteren Antriebsspindel 18 wirkverbunden, die ebenfalls durch einen steuerbaren Motor 19 angetrieben wird, dem ebenfalls ein Encoder 20 zugeordnet ist.

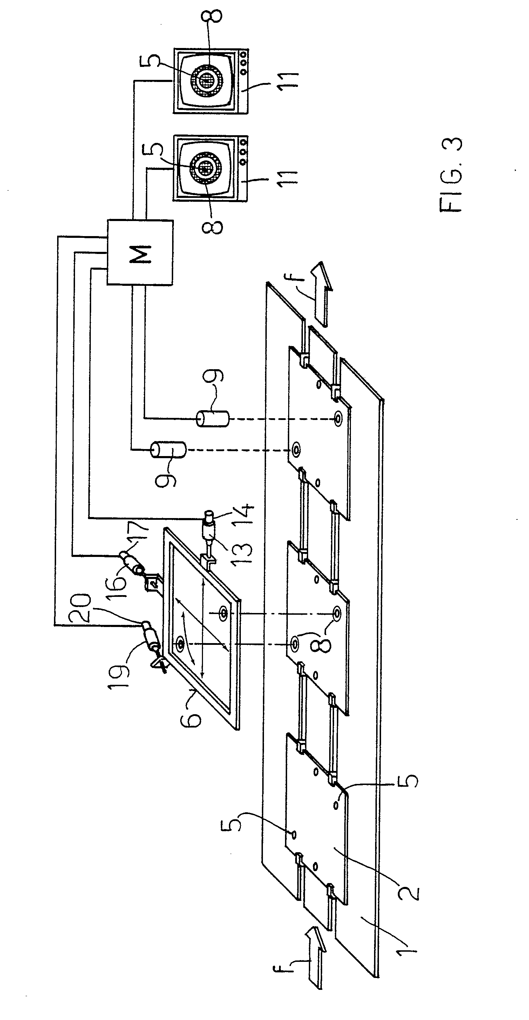

Die Encoder 14, 17 und 20 sind ueber elektrische Leitungen 21, die aus Gruenden der Uebersichtlichkeit lediglich in Fig. 3 dargestellt sind, mit einem Mikorprozessor M wirkverbunden.

In der Kontroll-und Entladezone III sind ueber den Bohrungen 5 Lageerkennungsmittel, in vorteilhafter Weise Fernsehkameras 9 angeordnet. Diese Fersehkameras 9 sind gegenueber den Platten 2 in ihrer Lage einstellbar und sind ueber elektrische Leitungen 10 mit einem Mikroprozessor M wirkverbunden. Ferner sind mit dem Mikroprozessor M Videoterminale 11 wirkverbunden.

Bilderkennungs-und Darstellungssysteme dieser Art werden z.B. von der Firma ORS-Object Recognition System, Princeton N.J., U.S.A angeboten und vertrieben.

Mit besonderem Vorteil sind die Fernsehkameras 9, sowie die Videoterminals 11 wirkverbunden und in ihrer Art so ausgewaehlt, dass eine stark vergroesserte Darstellung des Bildes auf den Videoterminals 11 moeglich wird.

Wenn ein Einstellen der Vorrichtung notwendig wird, so wird die Traegerplatte 2 ueber die Greifervorrichtung 4 in die Kontrollzone III transportiert, wo die Traegerplatte 2 auf vorher eingestelltenn bekannten Bezugsstiften abgesetzt wird. Mit den Fernsehkameras 9 wird die genaue Lage der Bohrungen 5 festgestellt, und die entsprechenden Koordinaten werden im Mikroprozessor M gespeichert. Waehrend dieses ersten Vorganges wird die Traegerplatte 2 nicht mit dem elektronischen Schaltkreis bedruckt und daher besteht keine Gefahr, dass Ausschuss produziert wird.

Nachdem die Lagekoordinaten fuer die Bohrungen 5 gespeichert wurden, wird dem Druckrahmen 6 eine Traegerplatte 2 zugefoerdert und es erfolgt ein mehr oder weniger registergenaues Einstellen der Plattenlage gegenueber dem Druckrahmen, z.B. durch Betaetigung der Motoren 13, 16 und/oder 19 ueber nicht dargestellte Druckschalter. Im Anschluss daran, wird eine Traegerplatte 2, die sich in der Beschickungszone I befindet, mit einem Papierblatt oder einem duennen Karton abgedeckt, z.B. unter Zuhilfenahme eines Klebebandes. Im Anschluss daran wird die so vorbereitete Traegerplatte 2 in die Druckzone II befoerdert, der Druckvorgang erfolgt und das Bild 8 des Schaltkreises wird auf die Platte 2 uebertragen. Im vorstehenden Fall sind aus Gruenden der Einfachheit als zu uebertragendes Bild zwei Ringe 8 dargestellt, die exakt registergenau die in die Traegerplatte 2 eingebrachten Bohrungen 5 umringen muss. Im Anschluss wird die bedruckte Traegerplatte 2 unter Zuhilfenahme der Greifervorrichtung 4 in die Kontrollzone III befoerdert und dort auf Bezugsstifte 3, die in entsprechende Bezugsbohrungen eingesetzt werden, abgesetzt. Im Anschluss daran stellen die Fernsehkameras 9 erneut die Lagekoordinaten der zwei Bilder 8 dar, und die ermittelten Werte werden erneut dem Mikorprozessor M zugefuehrt, welcher die Werte abspeichert. Auf dem Videoterminal 11 werden die Bilder 8 stark vergroessert dargestellt. In einem weiteren Vorgang vergleicht der Mikoprozessor die Daten bezueglich der Lage, die im vorangegangenen Vorgang fuer die Bohrungen 5 festgestellt wurde, mit den Daten bezueglich der ebenfalls abgespeicherten Lage der Bilder 8 im Mikroprozessor. Sofern die Bohrungen 5 genau konzentrisch von den Ringen 8 des Bildes des elektronischen Schaltkreises umgeben werden, werden durch den Mikroprozessor M in einer bekannten Vergleichereinheit keine Differenzsignale gebildet. Wird hingegen festgestellt, dass die ringfoermigen Abbildungen 8 die Bohrungen 5 nicht genau konzentrisch umgeben, so wird im Mikroprozessor ein Differenzsignal gebildet, welches ueber ein Programm verarbeitet wird und dazu dient, die entsprechenden Motoren 13, 16 und 19 fuer eine Korrekturverschiebung des Rahmens 6 anzutreiben. Das Ruecksignal bezueglich der anschleissend eingenommenen Stellung des Rahmens wird erneut dem Mikroprozessor M ueber die entsprechenden Resolver oder Encoder 14, 17 und 20 zugefuehrt, und diese Lagewerte koennen erneut im Mikorprozessor abgespeichert werden.

Unter Verwendung der Telekameras 9 wird eine staendige Kontrolle der Lage der Bilder 8 gegenueber der Bohrung 5 erreicht, und im Falle von Abweichungen kann automatisch eine Korrektur ueber den Mikroprozessor M eingeleitet werden. Somit wird eine staendige Kontrolle und ein automatisches, registergenaues Ausrichten zwischen Bohrung 5 der Traegerplatte 2 und dem durch Siebdruck aufgebrachten Schaltkreis 8 gewaehrleistet.

Es ist sehr vorteilhaft, dass die Erkennung der genannten Lagen nach dem Druckvorgang erfolgt, denn somit ist es moeglich, dass der Korrekturvorgang automatisch auch eventuelle, unumgaengliche Verformungen des Siebdruckrahmens 6 beruecksichtigt.

Sofern es erwuenscht ist, auf den Mikorprozessor M und die entsprechenden Steuerprogramme zu verzichten, so kann auf die Stellmotoren 13, 16 und 19 z.B. ueber Druckschalter eingewirkt werden, wodurch es ebenfalls ermoeglicht wird, die Lagekorrektur des Druckrahmens 6 gegenueber der Traegerplatte 2 vorzunehmen.

**Ansprüche**

1. Verfahren zum registergenauen Aufdruck eines elektronischen Schaltkreises gegenueber den in eine Traegerplatte eingebrachten Bezugsbohrungen, <u>dadurch gekennzeichnet</u>, dass folgende Verfahrensschritte zur Anwendung kommen.

a) ungefaehres Ausrichten des Druckrahmens - (6) gegenueber der Traegerplatte (2) des elektronischen Schaltkreises;

b) bildliche Darstellung von wenigstens zwei Bezugsbohrungen (5), die in die Traegerplatte (2) eingebracht sind, sowie Abspeichern der Lagekoordinaten fuer diese Bohrungen (5);

c) Abdruck des Bildes (8) des elektronischen Schaltkreises auf eine Traegerplatte (2), die mit einer Schutzschicht, z.B. aus Papier, abgedeckt wurde;

d) bildliche Darstellung des entsprechenden Bildes (8) des elektronischen Schaltkreises (Ringe), die den in die Traegerplatte eingebrachten Bohrungen (5) zugeordnet sind, sowie Abspeichern der Lagekoordinaten dieser Ringe (8) des Schalkreises;

e) Vergleich der Lagekoordinaten fuer die in die Traegerplatte (2) eingebrachten Bohrungen mit den entsprechenden Lagekoordinaten, der auf die Schutzschicht der Traegerplatte (2) aufgedruckten Schaltkreisringe (8);

f) Korrekturverschiebung des Druckrahmens - (6) in Richtung der Achsen (X, Y) und Verschwenken um die Achse (Z), entsprechend der festgestellten Registerabweichung.

2. Vorrichtung, zum registergenauen Aufdruck eines elektronischen Schaltkreises gegenueber den in eine Traegerplatte eingebrachten Bezugsbohrungen,dadurch gekennzeichnet , dass zwei in Ihrer Lage positionierbare Fersehkameras (9) vorgesehen sind, die den in die Traegerplatte (2) eingebrachten Bohrungen (5) zugeordnet sind, dass diese Fernsehkameras (9) mit einem Mikroprozessor (M) wirkverbunden sind, dessen Ausgaenge mit entsprechenden Videoterminals (11) wirkverbunden sind und, dass der Druckrahmen (6) mit steuerbaren Stellmotoren (13, 14, 16, 17) wirkverbunden ist, denen Encoder-Einrichtungen (14, 17, 20) zugeordnet sind, und der Rahmen (6) in Richtung der Achsen (X, Y) des Rahmens (6) verschiebbar ist, dass der Druckrahmen (6) ferner mit einem weiteren, steuerbaren Stellmotor (19) wirkverbunden ist, der ebenfalls mit einem Encoder (20) ausgeruestet ist, um eine Verschwenkbewegung um die Achse - (Z) durchzufuehren und, dass die Encoder-Vorrichtungen (14, 17, 20) mit dem Mikroprozessor (M) wirkverbunden sind.

3. Vorrichtung, nach Patentanspruch 2, dadurch gekennzeichnet, dass eine aus Fernsehkamera (9), Videoterminals (11) und Mikroprozessor (M) bestehende Vorrichtung der Type "Generalized Paralell Interface" for i-line with LSI, ADM-11 terminal der Firma ORS-Object Recognition System, Princeton N.J., U.S.A. Verwendung findet.

4. Vorrichtung, nach Patentanspruch 2, dadurch gekennzeichnet, dass die Fernsehkameras (9) einstellbar gegenueber der Traegerplatte und nach der Druckzone (II) angeordnet sind.

FIG.1

0 204 901

FIG. 2

0 204 901

FIG. 3

0 204 901